Europäisches Patentamt

(19) **European Patent Office**

Office européen des brevets

(11) Publication number: **0 100 676**
**B1**

## (12) EUROPEAN PATENT SPECIFICATION

(45) Date of publication of patent specification: **06.07.88**

(51) Int. Cl.⁴: **H 01 L 27/08**

(21) Application number: **83304445.6**

(22) Date of filing: **01.08.83**

(54) Resistors in semiconductor devices.

(30) Priority: **02.08.82 JP 133781/82**

(43) Date of publication of application:
**15.02.84 Bulletin 84/07**

(45) Publication of the grant of the patent:
**06.07.88 Bulletin 88/27**

(84) Designated Contracting States:
**DE FR GB**

(56) References cited:
**IBM TECHNICAL DISCLOSURE BULLETIN, vol. 20, no. 9, February 1978, pages 3507-3508, New York, US; M.VERHAEGHE: "General purpose master slice"**

(73) Proprietor: **FUJITSU LIMITED**
**1015, Kamikodanaka Nakahara-ku**
**Kawasaki-shi Kanagawa 211 (JP)**

(72) Inventor: **Ono, Chikai**
**322, Seki, Tama-ku**
**Kawasaki-shi Kanagawa 214 (JP)**
Inventor: **Okajima, Yoshinori**
**Fujitsu Dai-3 Fujigaoka-ryo 1, Fujigaoka 2-chome**
**Midori-ku Yokohama-shi Kanagawa 227 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to resistors in semiconductor devices.

Demand for smaller size circuits and higher density of packaging has been increasing in recent years. Such demand is particularly strong in the field of integrated circuits (IC's). Because of this, various techniques have been proposed for fabricating small-size circuit elements.

Techniques for fabricating small transistors and diodes have become considerably advanced. Some techniques used for transistors and diodes, however, cannot be applied to resistors. This is because each resistor must provide a specified design value of resistance. The resistance value is determined by the physical configuration of the resistor, e.g., its length and width. Therefore, the need for the correct physical configuration determines the limits of fine fabrication of resistors. This limits the degree of fine fabrication of resistors to some extent.

Previously, two methods have been proposed for arranging resistors to allow desirably fine fabrication. These methods, explained later, however, have certain problems. According to the first method, large dummy spaces are left between the resistors on the semiconductor substrate. According to the second method, the resistance value of each resistor cannot be obtained with a high degree of accuracy.

It is desirable to provide a semiconductor device wherein dummy spaces are minimized, while a high degree of accuracy of each resistor is maintained, thus enabling high density packaging of the semiconductor device.

According to the present invention there is provided a semiconductor integrated-circuit device having a plurality of mutually similar strip-shaped circuitry regions connected with respective elongate resistors each formed as a substantially straight strip, at least some of the resistors being of lengths greater than the respective widths of the circuitry regions connected with those resistors, the strip-shaped circuitry regions being arrayed alongside one another, one after another in a direction transverse to the longitudinal axes of those regions, and the resistors being arranged in an area of the device that extends across the said circuitry regions, characterised in that the longitudinal axes of the said resistors are parallel to one another and transverse to those of the said circuitry regions, and at least one of the said circuitry regions is crossed at least partially by more than one of the said resistors.

Reference will now be made, by way of example, to the accompanying drawings, wherein:

Figure 1 shows a schematic view of a memory circuit;

Figure 2 shows a plan view illustrating a prior method for arranging resistors in an integrated circuit;

Figure 3A shows a plan view illustrating another prior method for arranging resistors;

Figure 3B shows an enlarged plan view of an area enclosed by a broken line in Figure 3A;

Figure 4 shows a plan view of a semiconductor device having a resistor arrangement embodying the present invention;

Figure 5 shows a plan view of a resistor arrangement similar to the embodiment shown in Figure 4;

Figure 6 shows a plan view of a semiconductor device having another resistor arrangement embodying the present invention;

Figure 7 shows a plan view of another example of the embodiment shown in Figure 4;

Figure 8 shows a circuit diagram of one example of an application to which the present invention can be adapted;

Figure 9 shows a detailed plan view of a layout of the memory circuit shown in Figure 8; and

Figure 10 shows a plan view of a memory circuit with a layout according to the prior art resistor arrangement of Figure 2.

Before describing the preferred embodiments, a semiconductor device to which the present invention can be applied will be discussed. That is, the present invention deals with a semiconductor device including a plurality of resistors. The resistors are formed to correspond with a plurality of circuit blocks arranged successively and each having a constant width P. The resistors have substantially the same resistance value. In addition, each resistor has a length L which is longer than the width P (L>P). Of the circuits comprised by such a plurality of circuit blocks, the most typical is a memory circuit.

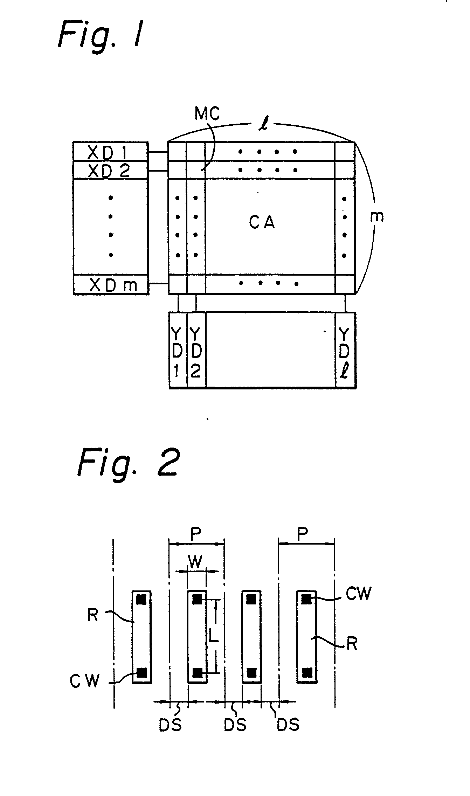

In Figure 1, which shows a schematic view of a memory circuit (taken as an example) to which the present invention can be applied, the characters CA represent a cell array, i.e. memory cell array, which is comprised of l×m numbers of memory cells MC arranged in a matrix. The cell array CA is provided with peripheral circuits, for example X driver circuits XD1, XD2, - - - XDm and Y driver circuits YD1, YD2, - - - YDm. These circuits access a specified one of the memory cells MC. These X driver circuits and Y driver circuits correspond to the previously mentioned plurality of circuit blocks arranged successively and each having the same width P. Methods for arranging the resistors formed in correspondence with such circuit blocks will be discussed below.

In the prior art method illustrated in Figure 2, the regions separated by chain dotted lines are the regions occupied by the resistors allowed for and corresponding to the circuit blocks. That is, each region having a width P corresponds to one of the X driver circuits (XD) or one of the Y driver circuits (YD), both shown in Figure 1. (It should be noted, that only four regions are illustrated for simplicity).

Each resistor R has a length L and a width W. Contact windows CW are formed at both ends thereof. The windows CW are connected with wirings (not shown). Incidentally, each resistor R may be a diffusion resistor, aluminum wiring resistor, or polysilicon resistor. Further, as previously mentioned, the relationships L>P, and

$W<P$, are satisfied.

From Figure 2, it will be apparent that, in the region allotted to each resistor R, considerably large idle spaces exist at the left and right sides. These spaces do not perform any function and are just dummy spaces DS. Such large dummy spaces DS make it difficult to achieve highly dense packaging of the circuit. In view of this, a method has been proposed for reducing the size of the dummy spaces DS to some extent.

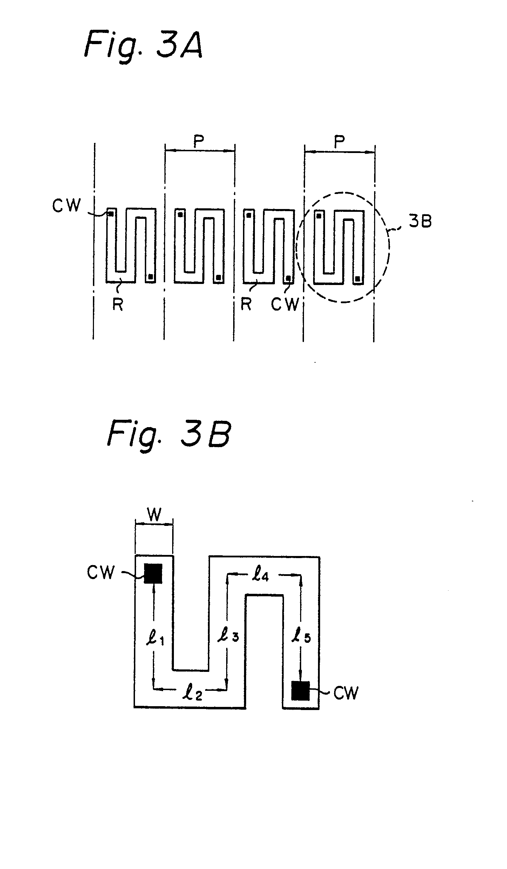

In Figure 3A, which illustrates such a method, and Figure 3B, which shows an enlarged plan view of an area enclosed by broken line 3B in Figure 3A, members the same as those of Figure 2 are represented by the same reference characters. As shown, each resistor R of Figures 3A and 3B has a zig-zag configuration. This reduces the dummy space DS. Further, the length of each resistor R in the vertical direction of the figure (corresponding to "$l_3$" in Figure 3B) can be made considerably shorter than the length L of the resistor in Figure 2. The length L is expressed as

$$L=l1+l2+l3+l4+l5.$$

As the result, highly dense packaging of the circuit can be realized.

A resistor R of such a zig-zag configuration, however, is inconvenient in that the actual resistance value thereof will deviate from the predetermined design value due to the four bent portions. As known, a uniform electric field cannot be created at each bent portion. Therefore, the resistance value at each bent portion deviates from the desired resistance value which would be observed under a uniform electric field.

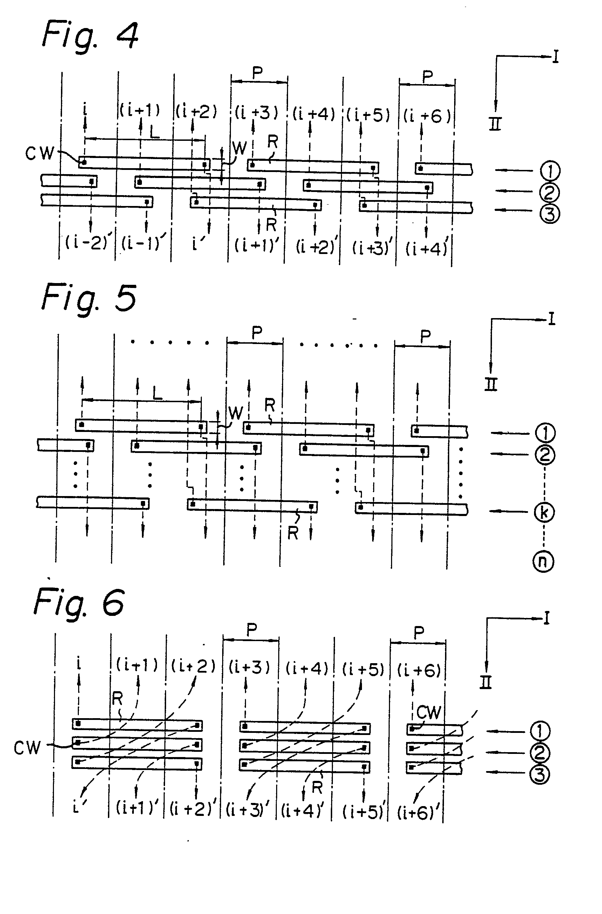

A plan view of a semiconductor device having a resistor arrangement embodying the present invention is shown in Figure 4, in which the regions separated by chain dotted lines are the same as those explained with reference to Figures 2 and 3A and correspond to the circuit blocks. Together these regions form the area which all the circuit blocks will occupy on the substrate. It should be noted, as previously mentioned, that the width of each region is P. Further, the resistors R are arranged so as to all be contained within the area which the circuit blocks will occupy. In Figure 4, however, not all the resistors R inside the area are completely illustrated.

Generally speaking, in the resistor arrangement pattern shown in Figure 4, the resistors R are arranged in a single line, each resistor R spanning several successive circuit block regions. The thus arranged single-line plurality of resistors constitute one linear array or "stage". Identical stages of the resistors are set up so as to be mutually-parallel and close to one another. In this arrangement method, firstly the length L and the width W of the resistor R are selected so as to give a desired resistance value (design value of resistance). Then the number of stages $n$ (where $n$ is a positive integer greater than or equal to 2) is selected so as to satisfy (at least substantially) the relationship $nP>L>(n-1)P$. Next, the resistors R, each having the chosen length L and width W, are arranged in a single line in a first direction (refer to arrow I in this figure) in which first direction the circuit block regions are arranged successively, and spanning over successive circuit block regions without overlapping of adjacent resistors R. After a plurality of resistors R have been arranged in a single line in the first direction I as the first stage ① $(n-1)$ identical further stages (in this figure, a further two, ② and ③) are set up in a close, mutually-parallel relationship out in a second direction (refer to arrow II in this figure) perpendicular to the first direction I.

Comparing the thus arranged resistors R with the resistors R arranged as shown in Figure 2, it will be understood that the useless dummy spaces DS shown in Figure 2 can be considerably reduced. This means that dense packaging of a circuit can be realized. Further, it will also be understood that since each resistor R of Figure 4 has a simple straight configuration, rather than a zig-zag configuration as in Figures 3A and 3B, the actual resistance value thereof can be almost the same as the design value and no significant deviation in value therebetween is produced. This can facilitate production of accurate resistors.

The thus arranged resistors R are connected with desired wirings via the contact windows CW formed at both ends there. It should be understood that the distribution of wirings is a matter of design choice. In this case, the wirings, of course, must not contact any other resistors R or wirings Therefore, when the resistors are diffusion resistors, it is necessary to distribute the wirings on an insulation layer formed, in advance, on the surface of the substrate.

In Figure 4, the wirings are indicated simply by broken arrows. For example, a resistor R having a wiring i at one end thereof is connected with another wiring i' at the other end thereof. These wirings i and i' are led, via predetermined wiring routes (not shown), to specified circuit portions to be connected therewith. This also applies to other wirings $(i+1)$, $(i+1)'$, $(i+2)$, $(i+2)'$, - - -.

Figure 5 is a plan view of a resistor arrangement according to the first embodiment shown in Figure 4, extended, however, from three stages to n stages. The principle behind the resistor arrangement is substantially the same as that of Figure 4. However, in Figure 5, the wiring pattern is more complicated than in Figure 4.

As seen from Figures 4 and 5, the resistors on one stage and the resistors on another stage are arranged shifted from each other (in echelon). That is, each resistor R arranged on an arbitrary k stage (k is an integer in a range of $2\leq k\leq n$) and each other resistor R arranged on a $(k-1)$ stage adjacent to the resistor R on the k stage are located shifted from each other in the first direction by rP (r is an integer in a range of $1\leq r\leq(n-1)$; in the example of Figure 5, r=1). It should be noted, however, that in embodiments of the present invention, there need be no such shift between adjacent resistors of different stages.

Another resistor arrangement embodying the present invention is shown in Figure 6, in which a three-stage ($\textcircled{1}$, $\textcircled{2}$, $\textcircled{3}$) resistor arrangement is illustrated. In this embodiment, each resistor R arranged on an arbitrary k stage (k is an integer in a range of $2 \leq k \leq n$; in this figure, n=3) and each other resistor R arranged on a (k−1) stage adjacent to the resistor R on the k stage are arranged in single file in the second direction II. That is, the resistors R of each of the stages are arranged respectively in register laterally with the resistors of the or each adjacent one of those arrays. In this case, since the contact windows CW of the resistors are vertically aligned, it is impossible to extend the wirings vertically as in Figure 4 or Figure 5. Therefore, the wiring for each contact window CW must be suitably distributed so as not to contact other contact windows CW, e.g. must be arranged as shown by the broken line arrows i, i', (i+1), (i+1)' - - -.

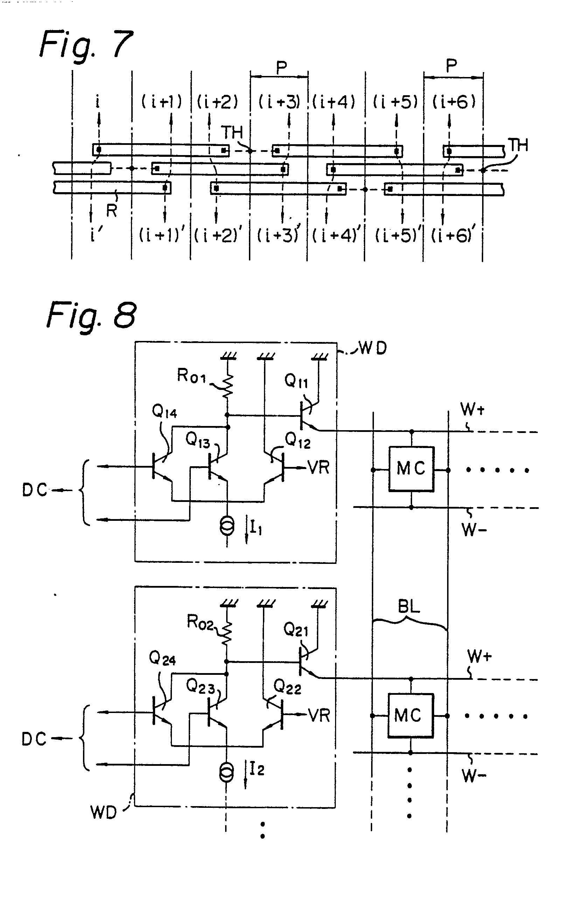

Another example of the embodiment shown in Figure 4 is shown in Figure 7 but with a partially modified wiring pattern. As will be seen from Figure 7 in some cases the wirings are effected from one resistor to another resistor or a through hole TH is created so as to lead the wiring to another wiring layer (not shown).

A memory circuit to which an embodiment of the present invention can be applied is shown in Figure 8. Since the memory circuit itself is irrelevant to the subject of the present invention, no detailed explanation thereof is given here. Reference characters MC represent memory cells. As in Figure 1, each memory cell MC is inserted between a positive side word $W_+$ and a negative side word line $W_-$. At the same time, each memory cell MC is inserted between a pair of bit lines BL. A word driver WD is driven when the corresponding memory cell MC is to be accessed. A decoder circuit DC selects one of the word drivers to be driven. Here, the aforesaid circuit blocks correspond to these word drivers WD. The subject of the present invention resides in how the resistors $R_{01}$, $R_{02}$ - - - in each driver WD should be arranged. Incidentally, the reference symbols $Q_{11}$ to $Q_{14}$ and $Q_{21}$ to $Q_{24}$ indicate transistors, VR a reference voltage, and $I_1$ and $I_2$ currents produced by respective constant current sources.

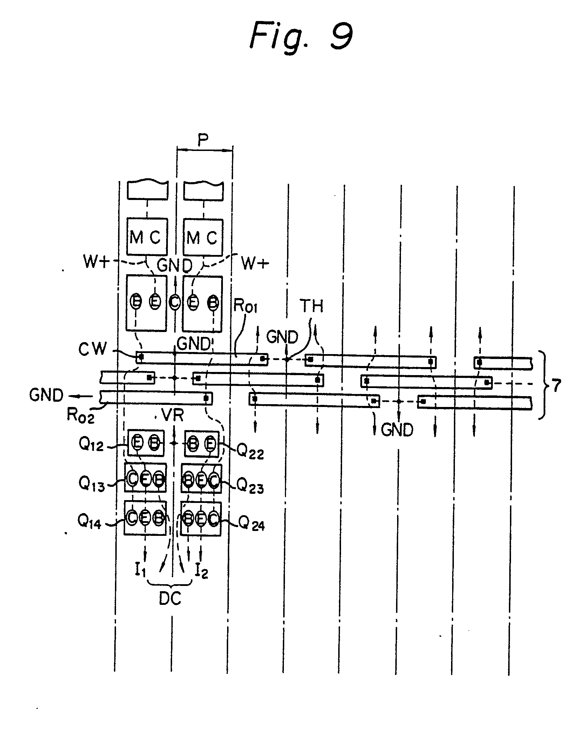

Figure 9 is a detailed plan view of a layout of the memory circuit shown in Figure 8. In this layout, the resistor arrangement of Figure 7 is employed as an example. The thus arranged resistors are located in an area 7. In Figure 9, portions related to those of Figure 8 are represented by the same reference characters or symbols. The characters B, E, and C, enclosed by circles, represent the base, emitter, and collector of each transistor, respectively. Gnd represents a ground (earth). As will be recognized from Figure 9, the use of a resistor arrangement, i.e., the area 7, embodying the present invention enables good balance in the layout of the memory circuit and, at the same time, highly dense packaging. This effect will be clear from a comparison with the aforementioned prior art resistor arrangements.

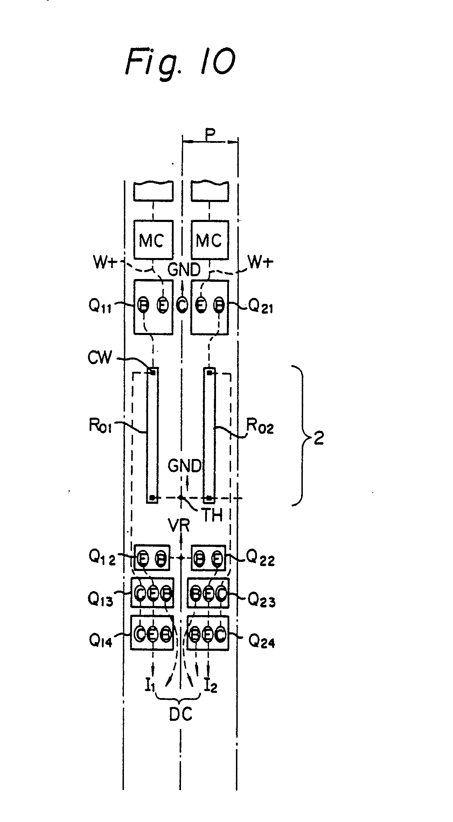

Figure 10 is a plan view of the memory circuit shown in Figure 8 with a layout according to the prior art resistor arrangement of Figure 2. The resistor arrangement of Figure 2 is employed in an area 2 of Figure 10. A comparison of the area 2 (prior art) of Figure 10 with the area 7 (embodiment of the invention) of Figure 9 shows that the layout of Figure 9 can enable higher density packaging than that of Figure 10.

As explained above in detail, in embodiments of the present invention, resistors can be arranged with high density packaging without reducing the accuracy of resistance values, thereby contributing to highly dense packaging of the semiconductor device.

It will be appreciated that if the relationship L<P holds the resistors R could be aligned one after another in a single line, and one in each circuit block, to allow highly dense packaging, so that the arrangements of the present invention would not be needed.

**Claims**

1. A semiconductor integrated-circuit device having a plurality of mutually similar strip-shaped circuitry regions connected with respective elongate resistors (R) each formed as a substantially straight strip, at least some of the resistors being of lengths (L) greater than the respective widths (P) of the circuitry regions connected with those resistors, the strip-shaped circuitry regions being arrayed alongside one another, one after another in a direction (I) transverse to the longitudinal axes of those regions, and the resistors being arranged in an area of the device that extends across the said circuitry regions, characterised in that the longitudinal axes of the said resistors (R) are parallel to one another and transverse to those of the said circuitry regions, and at least one of the said circuitry regions is crossed at least partially by more than one of the said resistors.

2. A device as claimed in Claim 1, wherein the said resistors (R) are arranged to form a plurality of laterally adjacent linear arrays ($\textcircled{1}$, $\textcircled{2}$, ... $\textcircled{K}$, ...), the resistors of each linear array being spaced apart one after another in the said direction (I).

3. A device as claimed in Claim 2, wherein the said resistors (R) of one of the said linear arrays ($\textcircled{1}$, $\textcircled{2}$, ...,$\textcircled{K}$, ...) are displaced longitudinally in relation to the respectively nearest resistors of an adjacent one of those linear arrays.

4. A device as claimed in Claim 2 or 3, wherein each of the said linear arrays ($\textcircled{1}$, $\textcircled{2}$, ... $\textcircled{K}$, ...) is displaced longitudinally, in relation to an adjacent one of those linear arrays, by a distance equal to an integral multiple r of the width (P) of each of the said circuitry regions, where r is in the range from 1 to (n−1), n being the number of the said linear arrays.

5. A device as claimed in Claim 2, wherein the resistors (R) of each of the said linear arrays ($\textcircled{1}$, $\textcircled{2}$, ...$\textcircled{K}$, ...) are arranged respectively in register laterally with the resistors of the or each adjacent one of those arrays.

6. A device as claimed in Claim 2, 3, 4 or 5, wherein the said resistors (R) are eual to one another in length L, the number *n* of the said linear arrays (①, ②, ... ⓚ, ...) being such as to satisfy at least substantially the relationship $nP > L > (n-1)P$, where P is the width of each of the said circuitry regions.

7. A device as claimed in any preceding claim, wherein the said circuitry regions comprise respective arrangements of semiconductor components, which arrangements are connected respectively with the said resistors (R) to form respective word drivers (WD) of a memory circuit.

**Patentansprüche**

1. Integrierte Halbleiterschaltungsvorrichtung mit einer Vielzahl von wechselseitig ähnlichen, streifenförmigen Schaltungsbereichen, die mit jeweils länglichen Widerständen (R) verbunden sind, von denen jeder als ein im wesentlichen geradliniger Streifen ausgebildet ist, wobei wenigstens einige von den Widerständen von einer Länge (L) sind, die größer als die jeweiligen Breiten (P) der Schaltungsbereiche ist, die mit jenen Widerständen verbunden sind, die streifenförmigen Schaltungsbereiche längs nebeneinander, einer nach dem anderen in einer Richtung (I) quer zu den Längsachsen von jenen Bereichen angeordnet sind, und die Widerstände in einem Bereich der Vorrichtung angeordnet sind, der sich quer über die genannten Schaltungsbereiche erstrekt, dadurch gekennzeichnet, daß die Längsachsen der genannten Widerstände (R) parallel zueinander und quer zu jenen der genannten Schaltungsbereiche sind, und wenigstens einer der genannten Schaltungsbereiche wenigstens teilweise von mehr als einem der genannten Widerstände gekreuzt wird.

2. Vorrichtung nach Anspruch 1, bei der die genannten Widerstände (R) angeordnet sind, um eine Vielzahl von seitlich benachbarten linearen Arrays (①, ②, ... ⓚ, ...) bilden, wobei die Widerstände jedes linearen Arrays mit Abstand voneinander, einer hinter dem anderen in der genannten Richtung (I) angeordnet sind.

3. Vorrichtung nach Anspruch 2, bei der die genannten Widerstände (R) von einem der genannten linearen Arrays (①, ②, ... ⓚ, ...) in Relation zu dem jeweils nächsten Widerstand von einem benachbarten jener linearen Arrays in Längsrichtung versetzt sind.

4. Vorrichtung nach Anspruch 2 oder 3, bei der jedes der linearen Arrays (①, ②, ... ⓚ, ...) in Relation zu einem benachbarten jener linearen Arrays in Längsrichtung um einen Abstand versetzt ist, der gleich einem ganzzahligen Vielfachen *r* der Breite (P) von jedem der genannten Schaltungsbereiche ist, wobei *r* im Bereich von 1 bis (*n*−1) und *n* die Zahl der genannten linearen Arrays ist.

5. Vorrichtung nach Anspruch 2, bei der die Widerstände (R) von jedem der genannten linearen Arrays (①, ②, ... ⓚ, ...) jeweils in seitlicher Ausrichtung mit den Widerständen von dem oder jedem benachbarten Array angeordnet sind.

6. Vorrichtung nach Anspruch 2, 3, 4 oder 5, bei der die genannten Widerstände (R) in der Länge L einander gleich sind, die Zahl *n* der genannten linearen Arrays (①, ②, ... ⓚ, ...) derart ist, daß wenigstens im wesentlichen die Relation $nP > L > (n-1)P$ erfüllt ist, wobei P die Breite von jedem der genannten Schaltungsbereiche ist.

7. Vorrichtung nach einem der vorhergehenden Ansprüche, bei der die genannten Schaltungsbereiche jeweilige Anordnungen von Halbleiterkomponenten umfassen, welche Anordnungen jeweils mit den genannten Widerständen (R) verbunden sind, um jeweilige Worttreiber (WD) einer Speicherschaltung zu bilden.

**Revendications**

1. Dispositif en circuit intégré à semi-conducteur comportant plusieurs régions de circuits similaires entre elles, en forme de bandes connectées à des résistances respectives allongées (R) formées chacune comme une bande pratiquement rectiligne, certaines au moins des résistances ayant des longueurs (L) supérieures aux largeurs respectives (P) des régions de circuits connectées à ces résistances, les régions de circuits en forme de bandes étant disposées le long les unes des autres, l'une après l'autre dans une direction (I) transversale par rapport aux axes longitudinaux de ces régions et les résistances étant disposées dans une zone du dispositif qui s'étend à travers lesdites régions de circuits, caractérisé en ce que les axes longitudinaux desdites résistances (R) sont parallèles entre eux et transversales par rapport à ceux desdites régions de circuits et en ce que l'une au moins desdites régions de circuits est croisée au moins partiellement par plus d'une desdites résistances.

2. Dispositif selon la revendication 1, dans lequel lesdites résistances (R) sont disposées de manière à former plusieurs réseaux linéaires voisins latéralement (①, ②, ... ⓚ, ...), les résistances de chaque réseau linéaire étant espacées les unes des autres dans ladite direction (I).

3. Dispositif selon la revendication 2, dans lequel lesdites résistances (R) de l'un desdits réseaux linéaires (①, ②, ... ⓚ, ...) sont décalées dans la direction longitudinale par rapport aux résistances respectivement les plus proches de l'un voisin des réseaux linéaires.

4. Dispositif selon la revendication 2 ou 3, dans lequel chacun desdits réseaux linéaires (①, ②, ... ⓚ, ...) est décalé dans la direction longitudinale par rapport à l'un voisin des réseaux linéaires d'une distance égale à un multiple entier *r* de la largeur (P) de chacune desdites régions de circuits, où *r* est dans la plage de 1 à (*n*−1), *n* étant le nombre desdits réseaux linéaires.

5. Dispositif selon la revendication 2, dans lequel les résistances (R) de chacun desdits réseaux linéaires (①, ②, ... ⓚ, ...) sont disposées respectivement en alignement latéral avec les résistances de celui ou de chacun desdits réseaux voisins.

6. Dispositif selon la revendication 2, 3, 4 ou 5, dans lequel lesdites résistances (R) ont la même longueur L entre elles, le nombre $n$ desdits réseaux linéaires (①, ②, ...Ⓚ, ...) étant tel qu'il satisfait au moins pratiquement la relation $nP>L>(n-1)P$, où P est la largeur de chacune desdites régions de circuits.

7. Dispositif selon l'une quelconque des revendications précédentes, dans lequel lesdites régions de circuits consistent en des dispositions respectives des composants semi-conducteurs, ces dispositions étant connectées respectivement avec lesdites résistances (R) pour former des circuits d'attaque de mot (WD) respectifs d'un circuit de mémoire.

# Fig. 1

# Fig. 2

# Fig. 3A

# Fig. 3B

## Fig. 4

## Fig. 5

## Fig. 6

## Fig. 7

## Fig. 8

## Fig. 9

# Fig. 10